(19) Europäisches Patentamt
European Patent Office
Office européen des brevets

(11) Publication number: **0 124 109**
**B1**

(12) **EUROPEAN PATENT SPECIFICATION**

(45) Date of publication of patent specification: 29.11.89

(51) Int. Cl.⁴: **H 01 H 50/16,** H 01 H 51/22, H 05 K 9/00

(21) Application number: 84104772.3

(22) Date of filing: 27.04.84

(60) Divisional applications 87107220, 87107219, 87107218, 87107171 filed on 18.05.87.

(54) Electromagnetic relay with symmetric reaction.

(30) Priority: 28.04.83 JP 64888/83 u
12.08.83 JP 126061/83 u
05.10.83 JP 187232/83
08.10.83 JP 188925/83

(43) Date of publication of application:
07.11.84 Bulletin 84/45

(45) Publication of the grant of the patent:
29.11.89 Bulletin 89/48

(84) Designated Contracting States:
AT BE CH DE FR GB IT LI LU NL SE

(56) References cited:
DE-A-3 320 000
DE-B-2 461 884

PATENT ABSTRACTS OF JAPAN; vol.7, no.36,
15 February 1983, page (E-158) (1181); &
JP-A-57-188816 (MATSUSHITA DENKO) 19-11-
1982

(73) Proprietor: OMRON TATEISI ELECTRONICS CO.
10, Tsuchido-cho Hanazono Ukyo-ku
Kyoto 616 (JP)

(72) Inventor: Bando, Yoshihide
78, Sakurazono-cho Kawashima
Nishikyo-ku Kyoto (JP)
Inventor: Maenishi, Kozo
5-29, Yakushido Imazato
Nagaokakyo-shi Kyoto (JP)
Inventor: Nakanishi, Yoichi
95-1, Matsumoto-cho Kami-gamo
Kita-ku Kyoto (JP)

(74) Representative: WILHELMS, KILIAN & PARTNER
Patentanwälte
Eduard-Schmid-Strasse 2
D-8000 München 90 (DE)

## Description

The present invention relates to an electromagnetic relay in which switch contacts are switched over by movement of an armature assembly in response to the energization of an electromagnet.

An electromagnetic relay as specified in the preamble of claim 1 is described and shown in JP—A—57-188816. An electromagnetic coil is wound on a bobbin, and an iron core is inserted through the middle of the bobbin. One end of the iron core lies between the pole pieces constituted by two end portions of the yoke member with a certain gap being defined therebetween.

The other end of the iron core is directly connected to the yoke member. Thus, when the electromagnet is energized, a magnetic circuit is created, and the two pole pieces of the yoke are magnetized to become poles of a particular polarity, for example in the case of energization in a particular direction they become south poles, while the end of the iron core between them is magnetized to become a pole of the opposite polarity, i.e. in this example becomes a north pole. An armature piece is made up by two iron plates being joined together by a plate shaped permanent magnet in approximately a C-shaped configuration, with one of the iron plates being thus magnetized to be a north pole and the other a south pole. This armature piece is positioned with the two iron plates inserted into the aforementioned gaps between the poles defined by said two end portions of the yoke member and the pole defined by said end of said iron core, and is mounted on a block member which can move from side to side so that the iron plates can move towards and away from said end of said iron core. Contacts are provided· which are opened and closed according to said sideways motion of said block member, either directly or via spring pieces which are bent thereby. Depending on the configuration, sideways biasing may be applied to the block member.

Thus, when the coil is energized in said particular direction, the one of the pole pieces which is magnetized to be a north pole by the permanent magnet is attracted to the pole piece of the yoke on its one side and is repelled from the side of the end of the iron core on its other side, while on the other hand the other one of the pole pieces which is magnetized to be a south pole by the permanent magnet is repelled from the pole piece of the yoke on its one side and is attrachted to the side of the end of the iron core on its other side; and thereby the block member is biased in a certain sideways direction, and moves so as to open or close certain of its contacts. On the other hand, when the coil is energized in the electrical direction opposite to said particular direction, the one of the pole pieces which is magnetized to be a north pole by the permanent magnet is repelled from the pole piece of the yoke on its one side and is attracted to the side of the end of the iron core on its other side, while on the other hand the other one of the pole pieces which is magnetized to be a south pole by the permanent magnet is attracted to the pole piece of the yoke on its one side and is repelled from the side of the end of the iron core on its other side; and thereby the block member is biased in the opposite sideways direction, and moves so as to close or open said certain of its contacts. (The position when the coil is not energized can be either of these positions or a position intermediate between them, depending on the biasing of the block member). Thereby the contacts are reliably and positively switched, and a good and efficient magnetic circuit with little loss of magnetic flux is provided.

In the known device the movement of the block member occurs to and fro along a line which is offset from the general center of the device including its center of gravity, which generally passes through or near the center of the electromagnetic coil. Therefore, when the relay performs switching action, an unbalanced and off center jerking force is caused to be applied to the base of the relay such as a printed circuit board to which the relay is fitted, and this off center jerking force creates a jerking torque around the center of gravity of the relay. This can give rise to various problems with regard to the fixing of the relay to the printed circuit board, and can mean that after a certain service life the fixing of the relay becomes loosened.

An expedient that might be thought of for curing the above outlined unbalance problem might be to provide two of the relay construction detailed above mounted back to back, so that the two forces due to the movements of their armature assemblies were on opposite sides of their center of gravity and the unbalanced portions thereof cancelled one another out; but this would increase the overall size and particularly the length of the device, and would increase its cost substantially.

A similar relay to that discussed above is shown in the prior but postpublished DE—A—3 320 000.

In prior but postpublished EP—A—127 308 a relay of the type is shown in which the relationship of disposition of core, yoke and armature and movement of the same is similar to that of the relay discussed above. However, there are two armature pieces, one on each end of the core, which can move independently of each other. EP—A—127 308 does not contain any specific information about the directions of magnetisation of the two armature pieces compared to each other and thus about whether these armatures move in the same or in opposite directions.

DE—B—2 461 884 discloses a switching device in which an armature which, at the same time, forms the core in a coil can freely move in a transversal direction and in parallel to itself inside the spool of the coil.

Accordingly, it is the primary object of the present invention to provide an electromagnetic relay of the type mentioned in the outset during the operation of which no off-center jerking forces are generated, which, thus, does not easily come loose from its mountings after some time in service. The relay shall be reliable in service and consistent in its operational properties. It shall be manufactured easily and cheaply and be compact in size.

The present invention is defined in the attached claim 1.

In this structure, since the directions of magnetization of the armature pieces are opposite, when the electromagnetic coil is energized and one of the two ends of the core becomes a north pole while the other becomes a south pole, the armature pieces are both impelled in the same direction transverse to the longitudinal axis of the coil and the core, so that the connecting member as a whole is impelled transversely thereby to switch the electrical connections. This action is performed in a symmetrical fashion with respect to the center of gravity of the device, and thus does not generate any off center jerking. Thus the mounting of the relay to a base is improved, because no torsional vibrations are generated during repeating switching actions which might lead to its being loosened therefrom.

The present invention will now be shown and described with reference to a preferred embodiment thereof, and with reference to the illustrative drawings.

Fig. 1 is a schematic perspective view of the main components of the magnetic circuit of the electromagnetic relay according to the present invention;

Fig. 2 is a graphic representation of this magnetic circuit;

Fig. 3 is a plan view of the inside of the relay with the actuating and connecting member removed;

Fig. 4 is a sectional view taken in a plane shown by the arrows A—A in Fig. 3;

Fig. 5 is a plan view of the inside of the relay with said actuating and connecting member in place.

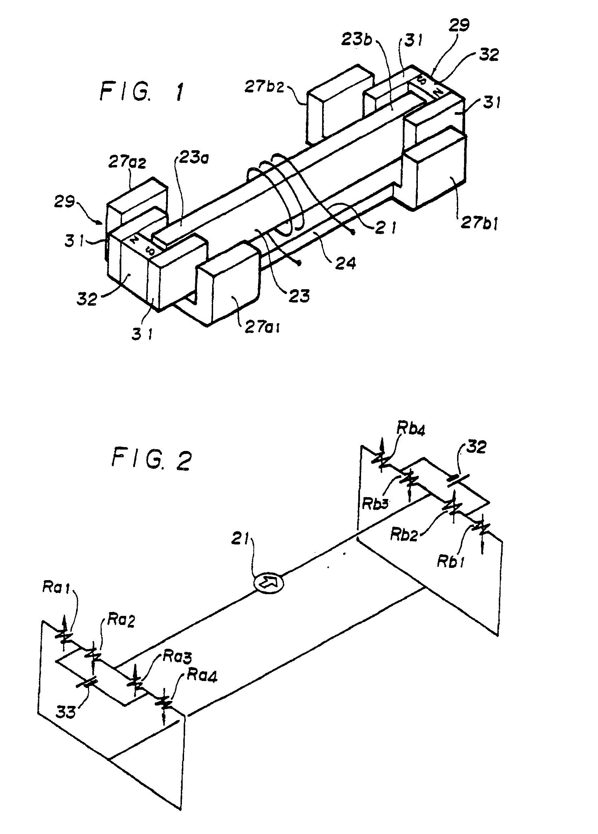

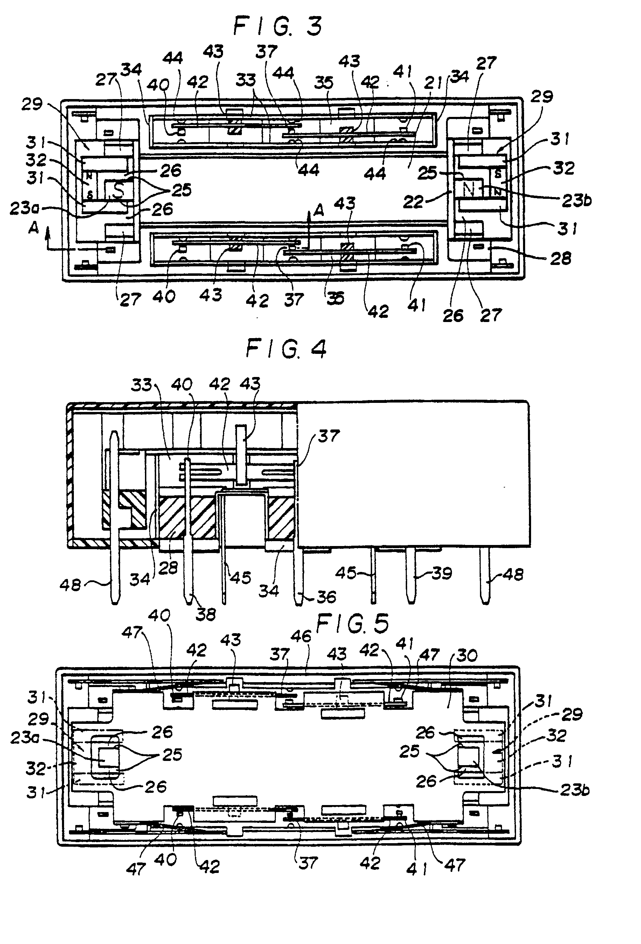

According to Fig. 1 an iron core 23 is fitted through the middle of a bobbin 22 (Fig. 3) on which an electromagnetic coil 21 is wound. The two ends 23a and 23b of this iron core 23 project out from the ends of the bobbin 22. A yoke member 24 is provided below the bobbin 22 (which in fact is fixed thereto although this is not shown in the figures) and the two ends of this yoke member 24 turn upwards as shown in Fig. 1, each being formed in two pole pieces 27a1, 27a2 and 27b1, 27b2. The two pole pieces 27a1 and 27a2 are positioned on opposite sides of the end 23a of the iron core 23 with gaps therebetween, and similarly the other two pole pieces 27b1 and 27b2 are on opposite sides of the other end 23b of the iron core 23 with gaps therebetween. The entire integrally fixed assembly of the coil 21, the bobbin 22, the iron core 23, and the yoke member 24 is fixed to a base 28 of the relay, best seen in Fig. 4 which is a sectional view of Fig. 3 along a plane shown by the arrows A—A in Fig. 3.

Two armature pieces 29 are each made up by two plate iron members 31 being fixed on opposite ends which define opposite poles of a plate shaped permanent magnet 32, in a generally C-shaped configuration, so that one of the plate members 31 is magnetized to be a north pole and the other is magnetized to be a south pole. Each of these two armature pieces 29 is fixed to one of the ends of an actuating and connecting member 30 (see Fig. 5), and projects downwards therefrom, with each of the plate iron members 31 being inserted into one of the gaps between one side of one end of the iron core 23 and one of the pole pieces 27 of the yoke 24, as best shown in Fig. 1. The actuating and connecting member 30 can move in the direction transverse to the longitudinal axis of the coil 21 and the iron core 23. The armature pieces 29 are fixed to the actuating and connecting member 30 with the poles of their permanent magnets 32 oriented in opposite directions. Fig. 2 shows an equivalent magnetic circuit for this construction: in this figure, the magnetic resistances of the gaps between the ends of the iron core 23 and the pole pieces 27 of the yoke member 24 and the iron members 31 are denoted by Ra1 through Ra4 and Rb1 through Rb4.

The electromagnetic relay construction shown can be applied either to a monostable type relay or to a latching type relay. In either case, sheet springs 47 (two on each side) are interposed between the sides of the actuating and connecting member 30 and rising portions 46 of the sides of the base 28 of the relay, with the one ends of the springs 47 fixed to said sides of said actuating and connecting member 30 by rivets or the like.

Contacts are provided for being opened and closed by the movement of the actuating and connecting member 30, as follows. Contact chambers 35 are provided on both sides of the bobbin 22, being defined and protected by side walls 33 and end walls 34 attached to the base 28, and along the center line of each of these chambers 35 there are provided, in order, an A contact 40 extending as an A terminal 38 near its one end, a common contact 37 extending as a common terminal 36 near its center, and a B contact 41 extending as a B terminal 39 near its other end. On each of the side walls 33 of the chambers 35 there are provided, opposing the contacts 40, 37 and 41, ground contacts 44 which are all connected to a ground temrinal 45. Terminals 48 are power supply terminals to the coil 21. Two contact pieces 42 are fixed along each side of the under side of the actuating and connecting member 30 by fixing members 43. These contact pieces 42 lie in the chambers 35 and are somewhat springy. In each chamber 35 one of the contact pieces 42 extends along from the A contact 40 to the common contact 37, and the other one of the contact pieces 42 along from the common contact 37 to the B contact 41. When the actuating and connecting member 30 is shifted in the upward direction in Fig. 5, each of the B terminals 39 of the electromagnetic relay is electrically connected to its corresponding common terminal 36 via the B contact 41, the corresponding contact pieces 42 and the common contact 37 whereas the A terminals 38 are disconnected from the common terminals 36. When the actuating and connecting member 30 is shifted in the downward direction in Fig. 5 it is the A terminals 38 which are electrically connected to their corresponding common terminals 36, and the B terminals 39 which are disconnected from the corresponding common terminals 38.

If the relay is in fact to be a monostable type relay the sheet springs 47 on one side of the actuating and connecting member 30 are made weaker than those on the other side so that the actuating and connecting member 30 is biased to one side. Thus, in the non-energized state of the electromagnetic coil 21, each of the B-terminals 39, for instance, is electrically connected to its corresponding common terminal 36 whereas the A terminals 38 are disconnected therefrom. This situation is shown in Fig. 3. Now, if the coil 21 is so energized that a north pole is developed in the core on the right hand side of Fig. 3 and a south pole is developed on the left hand side of Fig. 3, the armature pieces 29 are repelled downwards in the figure, thus moving the actuating and connecting member 30 smoothly and straight downwards by overcoming the spring action of the sheet springs 47 so as to disconnect the B terminals 39 from the common terminal 36 and simultaneously to connect the A terminals 38 to these common terminals 36. This occurs in a symmetric fashion with respect to the center of gravity of the electromagnetic relay, thus not generating any off-center jerking force or torque which could loosen the connection of the relay or of the terminals thereof. When the energization of the coil 21 is terminated the action of the sheet springs 47 restores the actuating and connecting member 30 and the armature pieces 29 mounted thereon to their original upwards displaced positions (Fig. 3) because in this case the action of the sheet springs 47 is arranged to be stronger than the attraction of the upper iron plates 31 to the end poles 23a, 23b of the iron core 23 caused by the permanent magnets 32 alone. This reverse switching action again occurs without developing any off-center jerking forces on the electromagnetic relay.

On the other hand, if the relay is in fact to be a bistable relay the sheet springs 47 on both of the sides of the actuating and connecting member 30 are made of roughly the same strength. The sheet springs 47 are arranged to be weaker than in the case described above, so that, when the coil 21 is not energized, the actuating and connecting member 30 is positioned in one position or the other, either upwards or downwards, according as to which way the coil 21 was last energized. From this state, if the coil 21 is energized in such a direction that a repellant force is generated for the iron plates 31 contacting the end poles 23a, 23b of the core 23 at this time the actuating and connecting member 30 will move to its opposite position. Movement takes place smoothly and straight downwards or upwards in Fig. 3 by overcoming the spring action of the sheet springs 47. This occurs in a symmetric fashion with respect to the center of gravity of the electromagnetic relay, thus not generating any off-center jerking force or torque which could loosen the connection of the relay or of the terminals thereof. On the other hand, in this case, when the energization of the coil 21 is terminated the action of the sheet spring 47 is not sufficient to move the actuating and connecting member 30 and the armature pieces 29 from the positions they had adopted since the attractive force between the end pole pieces 23a and 23b of the core 23 and the iron plates 31 contacting them is stronger than the action of the sheet springs 47 so that the actuating and connecting member 30 and the armature pieces 29 remain in their positions and the contact situation remains as described. This will be the case until the coil 21 is energized in the opposite direction to the previous one, causing the actuating and connecting member 30 and the armature pieces 29 to move back to their original positions. Thus, in summary, the action of the relay is that of a flip-flop device in this case.

## Claims

1. An electromagnetic relay, comprising:
a core (23) made of magnetic material,
an electromagnetic coil (21) wound around said core so that the two ends of said core project therefrom and constitute first and second core end poles (23a, 23b),
a yoke member (24) having first and second ends and extending generally parallel to said core, said yoke member (24) being formed at said first end thereof with two first pole pieces (27a1, 27a2) which lie one on each side of said first end pole (23a) of the core (23) with a certain gap being defined between said first end pole of the core and each of said first pole pieces (27a1, 27a2) of the yoke member,
a first armature piece (29) comprising a permanent magnet plate (32) and two plates (31) of magnetic material fixed to said permanent magnet plate so as to form a generally C-shaped body, with one of said magnetic material plates (31) being magnetized to be a north pole and the other one being magnetized to be a south pole, the two plates (31) of magnetic material being inserted one on each side of said first end pole of said core into the corresponding gap,
an actuating member (30) fixed to said first armature piece so as to be movable by the armature piece transversely to the longitudinal axis of said core and yoke, thereby establishing and breaking electrical connection between fixed and movable contacts (37, 40, 41; 42) of the relay,
characterized in that said yoke member (24) at its second end is formed with two second pole pieces (27b1, 27b2) which lie one on each side of said second evole (23b) of the core (23) with a certain gap similar to the afore-mentioned gaps being defined between said second end pole (23b) of the core (23) and each of said second pole pieces (27b1, 27b2) of the yoke member (24),

in that a second armature piece (29) similar to the first armature piece is provided, the two plates (31) of magnetic material of which being inserted one on each side of said second end pole of said core (23) into the corresponding gap,

in that the direction of magnetisation of said second armature piece (29) is oppositely oriented to that of said first armature piece (29), and

in that said actuating member (30) extends generally parallel to said core (23) and yoke member (24) between the two armature pieces (29) and is fixed also to the second armature piece, thus connecting the two armature pieces (29).

2. A relay according to claim 1, characterized in that in each of said armature pieces (29) said plates (31) of magnetic material are fixed to the north and the south pole of said permanent magnet plates (32).

3. A relay according to claim 1, characterized by further comprising means (47) for biasing said actuating and connecting member (30) in the direction transverse to its longitudinal axis.

4. A relay according to claim 3, characterized in that said biasing means (47) is strong enough to remove said plates (31) of magnetic material from said first and second ends (23a, 23b) of said core (23), when said coil (21) is not energized.

5. A relay according to claim 3, characterized in that said biasing means (47) is not strong enough to remove said plates (31) of magnetic material from said ends (23a, 23b) of said core (23), when said coil (21) is not energized.

**Patentansprüche**

1. Elektromagnetisches Relais mit
einem Kern (23) aus magnetischem Material,
einer um den Kern so gewickelten elektromagnetischen Spule (21), daß die beiden Enden des Kerns aus dieser herausragen und einen ersten und zweiten Kernendpol (23a, 23b) bilden,
einem Jochelement (24) mit einem ersten und zweiten Ende, welches sich im wesentlichen parallel zum Kern erstreckt, wobei das Jochelement (24) an seinem ersten Ende mit zwei ersten Polstücken (27a1, 27a2) ausgebildet ist, die jeweils einzeln auf jeder Seite des ersten Endpols (23a) des Kerns (23) unter Einhaltung eines gewissen Zwischenraums zwischen dem ersten Endpol des Kerns und jedem der ersten Polstücke (27a1, 27a2) des Jochelements liegen,
einem ersten Ankerteil (29), welches eine Permanentmagnetplatte (32) und zwei an der Permanentmagnetplatte befestigte Platten (31) aus magnetischem Material umfassen, so daß ein im wesentlichen C-förmiger Körper gebildet wird, wobei eine der Platten (31) aus magnetischem Material einen Nordpol bildend und die andere einen Südpol bildend magnetisiert ist, wobei die beiden Platten (31) aus magnetischem Material jeweils einzeln auf jeder Seite des ersten Endpoles des Kerns in den entsprechenden Zwischenraum eingesetzt sind,
einem Betätigungselement (30), welches an dem ersten Ankerteil so befestigt ist, daß es durch das Ankerteil quer zur Längsachse des Kerns und Jochs bewegbar ist, wodurch eine elektrische Verbindung zwischen festen und beweglichen Kontakten (37, 40, 41; 42) des Relais hergestellt und unterbrochen wird,

dadurch gekennzeichnet,
daß das Jochelement (24) an seinem zweiten Ende mit zwei zweiten Polstücken (27b1, 27b2) ausgebildet ist, welche jeweils einzeln auf jeder Seite des zweiten Endpols (23b) des Kerns (23) unter Einhaltung eines gewissen den vorgenannten Zwischenräumen ähnlichen Zwischenraums zwischen dem zweiten Endpol (23b) des Kerns (23) und jedem der zweiten Polstücke (27b1, 27b2) des Jochelements (24) liegen,

daß ein dem ersten Ankerteil ähnliches zweites Ankerteil (29) vorgesehen ist, dessen beide Platten (31) aus magnetischem Material jeweils einzeln auf jeder Seite des zweiten Endpolstücks des Kerns (23) in den entsprechenden Zwischenraum eingesetzt sind,

daß die richtung der Magnetisierung des zeiten Ankerteils (29) zu derjenigen des ersten Ankerteils (29) entgegengesetzt orientiert ist, und

daß das Betätigungselement (30) sich im wesentlichen parallel zu Kern (23) und Jochelement (24) zwischen den beiden Ankerteilen (29) erstreckt und auch am zweiten Ankerteil befestigt ist und so die beiden Ankerteile (29) miteinander verbindet.

2. Relais nach Anspruch 1, dadurch gekennzeichnet, daß in jedem der Ankerteile (29) die Platten (31) aus magnetischem Material am Nord- und am Südpol der Permanentmagnetplatten (32) befestigt sind.

3. Relais nach Anspruch 1, dadurch gekennzeichnet, daß es ferner Mittel (47) zum Vorbelasten des Betätigungs- und Verbindungselements (30) in Richtung quer zu dessen Längsachse umfaßt.

4. Relais nach Anspruch 3, dadurch gekennzeichnet, daß die Vorbelastungsmittel (47) stark genug sind, die Platten (31) aus magnetischem Material vom ersten und zweiten Ende (23a, 23b) des Kerns (23) zu entfernen, wenn die Spule (21) nicht erregt ist.

5. Relais nach Anspruch 3, dadurch gekennzeichnet, daß die Vorbelastungsmittel (47) nicht stark genug sind, die Platten (31) aus magnetischem Material von den Enden (23a, 23b) des Kerns (23) zu entfernen, wenn die Spule (21) nicht erregt ist.

**Revendications**

1. Un relais électromagnétique, comprenant:
un noyau (23) constitué d'un matériau magnétique,
une bobine électromagnétique (21) enroulée autour dudit noyau de sorte que les deux extrémités dudit noyau fasse saillie par rapport à la bobine et constituent les premier et deuxième pôles (23a, 23b) d'extrémités de noyau,
un élément en arceau (24) possédant des première et deuxième extrémités et s'étendant généralement de façon parallèle audit noyau, ledit élément en arceau (24) étant constitué à sa dite première extrémité par deux premières pièces polaires (27a1, 27a2) qui se situent chacune d'un côté de ladite première extrémité polaire (23a) du noyau (23) un certain intervalle étant défini entre ladite première extrémité polaire du noyau et chacune desdites premières pièces polaires (27a1, 27a2) de l'élément en arceau,

une première pièce d'armature (29) comprenant une plaque magnétique permanente (32) et deux plaques (31) d'un matériau magnétique fixées à ladite plaque magnétique permanente de manière à constituer un corps en forme générale de C, une desdites plaques en matériau magnétique (31) étant magnétisée afin d'être un pôle nord et l'autre étant magnétisée afin d'être un pôle sud, les deux plaques (31) de matériau magnétique étant insérée chacune d'un côté de ladite première extrémité polaire dudit noyau dans l'intervalle correspondant,

un élément d'actionnement (30) fixé à ladite première pièce d'armature de façon à être mobile par la pièce d'armature transversalement à l'axe longitudinal desdits noyau et arceau, établissant et coupant par là une liaison électrique entre les contacts fixes et mobiles (37, 40, 41; 42) du relais,

caractérisé en ce que ledit élément en arceau (24) est constitué à sa deuxième extrémité de deux secondes pièces polaires (27b1, 27b2) situées chacune d'un côté dudit deuxième pôle d'extrémité (23b) du noyau (23), un certain intervalle similaire aux intervalles mentionnés ci-dessus étant défini entre ledit deuxième pôle d'extrémité (23b) du noyau (23) et chacune desdites deuxièmes pièces polaires (27b1, 27b2) de l'élément en arceau (24),

en ce qu'il existe une deuxième pièce d'armature (29) similaire à la première pièce d'armature dont les deux plaques (31) de matériau magnétique sont insérées une de chaque coté dudit deuxième pôle d'extrémité dudit noyau (23) dans l'intervalle correspondant,

en ce que la direction de magnétisation de ladite deuxième pièce d'armature (29) est orientée à l'opposé de celle de ladite première pièce d'armature (29), et

en ce que ledit élément d'actionnement (30) s'étend de façon généralement parallèle auxdits noyau (23) et élément en arceau (24) entre les deux pièces d'armatures (29) et est fixé également à la deuxième pièce d'armature, reliant de cette façon les deux pièces d'armatures (29).

2. Un relais selon la revendication 1, caractérisé en ce que dans chacune desdites pièces d'armatures (29) lesdits plaques (31) de matériau magnétique sont fixées aux pôles nord et sud desdites plaques magnétiques permanentes (32).

3. Un relais selon la revendication 1, caractérisé en ce que qu'il comprend de plus des moyens (47) destinés à polariser ledit élément d'actionnement et de liaison (30) dans la direction transversale à son axe longitudinal.

4. Un relais selon la revendication 3, caractérsié en ce que ledit moyen de polarisation (47) est assez puissant pour retirer lesdites plaques (31) en matériau magnétique desdites première et deuxièmes extrémités (23a, 23b) dudit noyau (23), lorsuqe ladite bobine n'est pas excitée.

5. Un relais selon la revendication 3, caractérisé en ce que ledit moyen de polarisation (47) n'est pas assez puissant pour retirer les plaques (31) en matériau magnétique desdites extrémités (23a, 23b) dudit noyau (23), lorsque ladite bobine (21), n'est pas excitée.

FIG. 1

FIG. 2

FIG. 3

FIG. 4

FIG. 5